# EUROPÄISCHE PATENTSCHRIFT

(11) **EP 2 920 821 B1**
(45) Veröffentlichungstag und Bekanntmachung des Hinweises auf die Patenterteilung: **02.11.2016**
(21) Anmeldenummer: 13791989.0
(22) Anmeldetag: 13.11.2013
(51) Int. Cl.: H01L 31/05, H01L 31/18

(54) **VORRICHTUNG UND VERFAHREN ZUM AUFBRINGEN VON KONTAKTDRÄHTEN AUF SOLARZELLENWAFER**
APPARATUS AND METHOD FOR MOUNTING CONTACT WIRES ON SOLAR CELL WAFERS
DISPOSITIF ET PROCÉDÉ POUR APPLIQUER DES FILS DE CONTACT SUR DES TRANCHES DE SEMI-CONDUCTEUR DE CELLULE PHOTOVOLTAÏQUE

(30) Priorität: 14.11.2012 DE 102012220815
(43) Veröffentlichungstag der Anmeldung: 23.09.2015
(73) Patentinhaber: Schmid Technology Systems GmbH, 78078 Niedereschach (DE)
(72) Erfinder: KRAUSE, Benjamin, Aichhalden 78733 (DE); PÖNISCH, Christoph, 09599 Freiberg (DE); ITTA, Günter, 78050 Villingen-Schwenningen (DE); SEIFRIED, Martin, 78628 Rottweil (DE)
(74) Vertreter: Patentanwälte Ruff, Wilhelm, Beier, Dauster & Partner mbB
(86) Internationale Anmeldenummer: PCT/EP2013/073736
(87) Internationale Veröffentlichungsnummer: WO 2014/076134

(56) Entgegenhaltungen:
- EP-A1- 2 439 782
- EP-A2- 0 095 843
- DE-A1-102010 016 476
- US-A1- 2006 219 352

## Beschreibung

Die Erfindung bezieht sich auf eine Vorrichtung und ein Verfahren zum Anbringen von serienverschaltenden Solarzellen-Kontaktdrähten, die in einer Stringrichtung durchgehend auf einer Oberseite eines vorderen Solarzellenwafers und einer Unterseite eines auf den vorderen Solarzellenwafer in einem zu bildenden Solarzellenstring folgenden, hinteren Solarzellenwafers verlaufen.

Es ist bekannt, mehrere Solarzellenwafer, vorliegend auch kurz als Wafer bezeichnet, unter Bildung eines sogenannten Solarzellenstrings elektrisch in Reihe zu schalten, indem mittels Kontaktdrähten die Oberseite eines Solarzellenwafers elektrisch mit der Unterseite eines im String folgenden Solarzellenwafers kontaktiert wird. Unter Solarzellenwafer ist hierbei vorliegend jegliche herkömmliche Anordnung einer oder mehrerer auf einem Wafer integrierter Fotovoltaikzellen zu verstehen, die über entsprechende Anschlüsse an der Oberseite und Unterseite verfügt, typischerweise in Form von Frontkontakt- und Rückkontaktstrukturen, die punktuelle und/oder linienförmige Strukturelemente beinhalten können. Unter den Begriffen Oberseite und Unterseite sind hierbei vorliegend allgemein die beiden Hauptseiten des Solarzellenwafers zu verstehen, von denen eine Seite als Frontkontaktseite bzw. Lichteinstrahlseite und die andere Seite als Rückkontaktseite fungiert, ohne dass damit eine bestimmte räumliche Lage spezifiziert sein soll.

In der älteren deutschen Patentanmeldung 102011081674.7 der Anmelderin sind ein Verfahren und eine Vorrichtung der eingangs genannten Art beschrieben. Die Vorrichtung umfasst eine Waferhaltevorrichtung, auf der die Solarzellenwafer in der Stringrichtung hintereinander an zugehörigen Waferhaltepositionen positionierbar sind, und eine Drahtlegemechanik, die eine über der Waferhaltevorrichtung beweglich angeordnete Drahtführung mit zugehörigem Drahtschneider aufweist, sowie eine Drahthaltegreifermechanik mit Drahtgreifern jeweils zwischen den Waferhaltepositionen sowie vor der vordersten und hinter der hintersten Waferhalteposition. Zuerst wird vor Positionieren eines im String vordersten Wafers dessen Waferhalteposition mit den Kontaktdrähten belegt. Dazu bewegt sich die Drahtführung mit den parallelen, abzulegenden Kontaktdrähten zum Drahthaltegreifer hinter der Waferhalteposition, übergibt die Kontaktdrahtenden an diesen und bewegt sich dann zum Drahthaltegreifer vor der Waferhalteposition, übergibt die Drähte an diesen und schneidet sie ab. Dann wird der vorderste, erste Wafer auf seine Halteposition aufgelegt, so dass die zuvor abgelegten Kontaktdrähte gegen seine Unterseite anliegen. Anschließend erfolgt das serienverschaltende Anbringen der Kontaktdrähte auf der Oberseite des vordersten Wafers und der Unterseite des nächsten Wafers. Dazu bewegt sich die Drahtführung zum Drahthaltegreifer hinter der Waferhalteposition für den zweiten Wafer, übergibt die Kontaktdrähte an selbigen und bewegt sich dann bis vor den vordersten Wafer. Anschließend wird ein Niederhalter auf der Oberseite des ersten Wafers mit den darüber gespannten Kontaktdrähten platziert, der die Kontaktdrähte dort in Position hält. Daraufhin werden die Kontaktdrähte vom Drahtschneider an der Drahtführung abgeschnitten, und der zweite Wafer wird auf seine mit den Kontaktdrähten belegte Halteposition aufgelegt. Dann fährt die Waferhaltevorrichtung um eine Halteposition vor, und der geschilderte Kontaktdrahtlegevorgang wird mit dem nächsten Waferpaar durchgeführt, d.h. zum Anlegen der Kontaktdrähte auf die Oberseite des zweiten Wafers und die Unterseite des nächsten, dritten Wafers. Bei diesem Verfahren bewegt sich folglich die Drahtführung zunächst um zwei Waferlängen vor, d.h. in Stringrichtung nach hinten, um die Kontaktdrahtenden an den betreffenden Drahthaltegreifer zu übergeben, und dann wieder um zwei Waferlängen zurück, d.h. in Stringrichtung nach vorn, um die Kontaktdrähte über die Halteposition des noch nicht positionierten nächsten Wafers und die Oberseite des positionierten vorderen Wafers zu spannen, wobei sie jeweils die Kontaktdrähte führt.

Die Offenlegungsschrift DE 102010016476 A1 offenbart ein Verfahren und eine Vorrichtung zum Aufbringen von Kontaktdrähten auf eine Oberfläche einer Fotovoltaikzelle unter Verwendung einer Positionier- und Ablegeeinrichtung, die eine Mehrzahl von Düsen oder Ösen aufweist, wobei jeweils mindestens ein Kontaktdraht durch die jeweilige Düse oder Öse geführt wird, um ihn auf die Oberfläche der Fotovoltaikzelle zu positionieren und abzulegen.

Der Erfindung liegt als technisches Problem die Bereitstellung einer Vorrichtung und eines Verfahrens der eingangs genannten Art zugrunde, die ein gegenüber dem oben erläuterten Stand der Technik verbessertes Anbringen der serienverschaltenden Solarzellen-Kontaktdrähte auf der Ober- bzw. Unterseite je zweier benachbarter Solarzellenwafer eines zu bildenden Solarzellenstrings ermöglichen.

Die Erfindung löst dieses Problem durch die Bereitstellung einer Vorrichtung mit den Merkmalen des Anspruchs 1 und eines Verfahrens mit den Merkmalen des Anspruchs 6. Vorteilhafte Weiterbildungen der Erfindung sind in den Unteransprüchen angegeben, deren Wortlaut hiermit durch Verweis zur Vermeidung unnötiger Textwiederholung in die Beschreibung aufgenommen wird.

Die erfindungsgemäße Vorrichtung umfasst eine Waferhaltevorrichtung, auf der die Solarzellenwafer in der Stringrichtung hintereinander an zugehörigen Waferhaltepositionen positionierbar sind, und eine Drahtlegemechanik. Die Drahtlegemechanik beinhaltet einen Drahtzufuhrgreifer und einen gegenüber diesem in der Stringrichtung verfahrbaren Drahttransportgreifer, die über der Waferhaltevorrichtung angeordnet sind, sowie einen Drahthaltegreifer zum Greifen und Halten der Kontaktdrähte hinter der Waferhalteposition für den hinteren Solarzellenwafer und einen Drahtschneider. Um die Oberseite eines vorderen und die Unterseite eines nachfolgenden Solarzellenwafers mit den serienverschaltend durchgehenden Kontaktdrähten zu versehen, steuern entsprechende Drahtlege-Steuermittel die Drahtlegemechanik derart, dass nach Positionieren des vorderen Wafers und vor Positionieren des hinteren Wafers auf ihrer jeweiligen Waferhalteposition die Kontaktdrähte vom Drahtzufuhrgreifer an den Drahttransportgreifer übergeben und von letzterem in der Stringrichtung über die Waferhalteposition für den hinteren Wafer und über die Oberseite des positionierten vorderen Wafers vorbewegt werden, d.h. entlang des zu bildenden Solarzellenstrings nach vorn. Hinter der Waferhalteposition für den hinteren Wafer werden die Kontaktdrähte vom Drahthaltegreifer gegriffen und gehalten. Danach können sie hinter dem Drahthaltegreifer vom Drahtschneider abgeschnitten werden. Daran kann sich das Positionieren des hinteren Solarzellenwafers auf seiner zugehörigen Waferhalteposition anschließen. Mit dieser erfindungsgemäßen Drahtlegekinematik lassen sich die Kontaktdrähte in einer sehr effektiven und funktionell zuverlässigen Weise durchgehend auf die Oberseite des vorderen Wafers und die Unterseite des anschließenden hinteren Wafers anbringen, um die Wafer im String seriell zu verschalten.

In einer Weiterbildung der Erfindung beinhaltet das Übergeben der Kontaktdrähte vom Drahtzufuhrgreifer an den Drahttransportgreifer, dass der Drahtzufuhrgreifer von einer Drahtklemmstellung in eine Drahtfreigabestellung und der Drahttransportgreifer von einer Drahtfreigabestellung in eine Drahtklemmstellung gesteuert werden. In der Drahtklemmstellung hält der jeweilige Greifer die Kontaktdrähte fest, in der Drahtfreigabestellung gibt er sie frei, d.h. er lässt sie los.

In einer Weiterbildung der Erfindung erfolgt das Abschneiden der Kontaktdrähte an einer Stelle zwischen dem Drahtzufuhrgreifer und dem Drahthaltegreifer, wobei der Drahtzufuhrgreifer von einer Drahtfreigabestellung in eine Drahtklemmstellung gesteuert wird, bevor die Kontaktdrähte abgeschnitten werden. Dadurch hält der Drahtzufuhrgreifer die Kontaktdrähte zum Abschneiden zufuhrseitig fest. Er kann sie dann wieder an den Drahttransportgreifer übergeben, um den nächsten Kontaktdrahtlegevorgang durchzuführen.

In einer Ausgestaltung der erfindungsgemäßen Vorrichtung ist der Drahtschneider durch zwei planparallel gegeneinander verschiebbare Schneidplatten gebildet, die mit zusammenwirkenden Drahtdurchführungsöffnungen versehen sind. Vorteilhaft weisen die Drahtdurchführungsöffnungen der zufuhrseitigen Schneidplatte eine konisch verjüngte Form auf.

In einer Weiterbildung der Erfindung werden die vorbewegten Kontaktdrähte zwischen der Oberseite des vorderen Wafers und der Waferhalteposition für den hinteren Wafer mittels eines Drahtbiegers von einem Niveau der Oberseite des vorderen Wafers auf ein Niveau der Waferhalteposition für den hinteren Wafer abgebogen. Dadurch kann für die Kontaktdrähte in diesem Übergangsbereich zwischen den beiden elektrisch seriell zu verbindenden Solarzellenwafern eine definierte Biege- bzw. Abknickcharakteristik z.B. mit einem etwa Z-förmigen Verlauf erzielt werden.

In einer Weiterbildung der Erfindung wird nach dem Vorbewegen der Kontaktdrähte ein Niederhalter auf die Oberseite des vorderen Wafers aufgelegt. Der Niederhalter hält dann dort die Kontaktdrähte in Position. Der Drahttransportgreifer kann demgemäß die Kontaktdrähte freigeben, d.h. loslassen, und in eine Position zur erneuten Kontaktdrahtübergabe vom Drahtzufuhrgreifer zurückbewegt werden.

Vorteilhafte Ausführungsformen der Erfindung sind in den Zeichnungen dargestellt und werden nachfolgend beschrieben. Hierbei zeigen:
- Fig. 1: eine schematische Seitenansicht eines erfindungswesentlichen Teils einer Vorrichtung zum Anbringen von serienverschaltenden SolarzellenKontaktdrähten,
- Fig. 2: eine Perspektivansicht auf die Vorrichtung von Fig. 1 in einer Ausgangsstellung zu Beginn eines Drahtlegevorgangs,
- Fig. 3: eine schematische Detailseitenansicht eines über einer Waferhaltevorrichtung liegenden Teils einer Drahtlegemechanik der Vorrichtung von Fig. 2,
- Fig. 4: eine Ansicht entsprechend Fig. 2 nach Vorbewegen eines Drahttransportgreifers,
- Fig. 5: eine schematische Detailseitenansicht ähnlich Fig. 3 in einem Drahtschneidestadium des Drahtlegevorgangs,
- Fig. 6: eine Ansicht entsprechend Fig. 4 im Drahtschneidestadium entsprechend Fig. 5,
- Fig. 7: eine perspektivische Detailansicht des Übergangsbereichs zwischen einem positionierten Solarzellenwafer und einer noch unbelegten Waferposition zur Veranschaulichung dort befindlicher Drahtbiegeelemente,
- Fig. 8: eine Teilseitenansicht der Vorrichtung gemäß den Fig. 1 bis 7,
- Fig. 9: eine Detaillängsschnittansicht des Bereichs von Fig. 7,
- Fig. 10: die Perspektivansicht von Fig. 6 im Prozessstadium nach Auflegen eines Waferniederhalters,
- Fig. 11: die Perspektivansicht von Fig. 10 nach Rückbewegen des Drahttransportgreifers und

- Fig. 12: die Perspektivansicht von Fig. 11 am Ende des Drahtlegevorgangs.

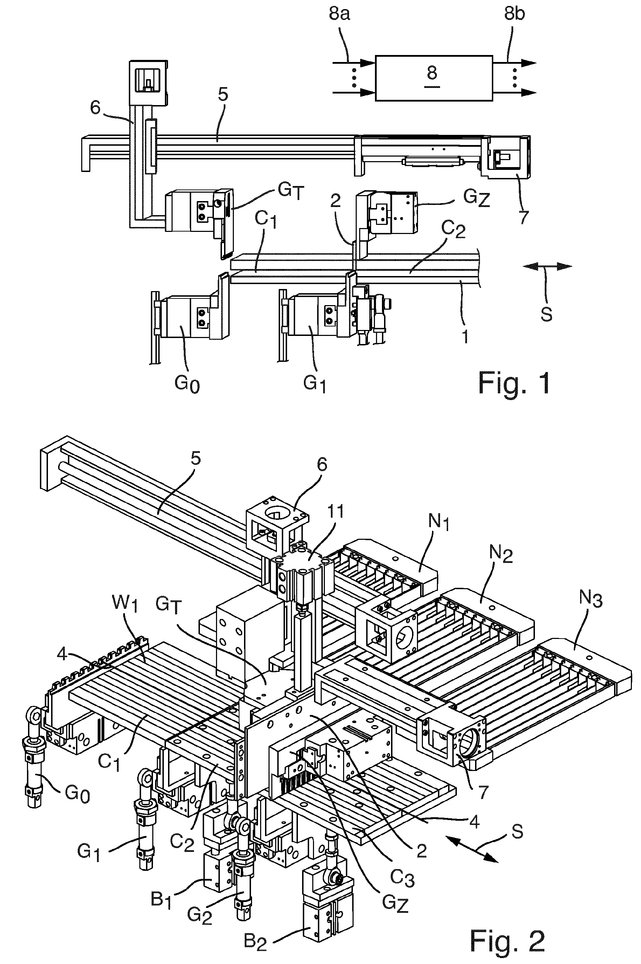

In Fig. 1 ist schematisch ein vorliegend interessierender Teil einer Vorrichtung zum Anbringen von serienverschaltenden Solarzellen-Kontaktdrähten dargestellt, mit denen eine vorgebbare Anzahl n von Solarzellenwafern mechanisch und elektrisch zu einem Solarzellenstring gekoppelt werden, in welchem die Solarzellenwafer elektrisch in Reihe geschaltet sind. Dazu verlaufen die Kontaktdrähte in einer Stringrichtung, d.h. parallel zur Richtung, in welcher die Solarzellenwafer im String aufeinander folgen, durchgehend auf einer Oberseite eines jeweils vorderen Solarzellenwafers und einer Unterseite eines diesem folgenden, hinteren Solarzellenwafers. Zusätzlich wird dann noch die Unterseite des im String vordersten Solarzellenwafers und die Oberseite des im String hintersten Solarzellenwafers mit Kontaktdrähten belegt. Die Kontaktdrähte können von irgendeinem beliebigen Querschnitt sein, wie sie herkömmlicherweise für diese Anwendung gebräuchlich sind.

Die Kontaktdrähte stellen für die verschiedenen Teilbereiche auf der Oberseite und der Unterseite jedes Solarzellenwafers eine elektrische Ankopplung nach außen bereit. Dazu können die Kontaktdrähte selbst zugehörige Front- und Rückkontaktstrukturen bilden oder mit auf der Waferoberseite und der Waferunterseite bereits vorhandenen Front- /Rückkontaktstrukturen kontaktiert werden. Die Solarzellenwafer können von irgendeinem der herkömmlichen Typen sein, die sich für diese Art von Serienverschaltung mittels aufgebrachter Kontaktdrähte eignen.

Wie in Figur 1 schematisch dargestellt, beinhaltet die erfindungsgemäße Vorrichtung in dieser exemplarischen Realisierung eine ausschnittweise gezeigte Waferhaltevorrichtung 1, hier in Form eines üblichen Wafertisches, der in Stringrichtung S horizontal verfahrbar ist und auf dem die Solarzellenwafer in der Stringrichtung S hintereinander an zugehörigen Waferhaltepositionen positionierbar sind, die durch entsprechende Vakuumansaug-Trägerplatten C₁, C₂, ...,Cₙ, sogenannte Chucks, gebildet sind. Beispielsweise können die Solarzellenwafer "Sunny-Side-Up", d.h. mit ihrer Frontkontaktseite nach unten, auf die Chucks C₁ bis Cₙ aufgelegt werden.

Des Weiteren beinhaltet die Vorrichtung eine Drahtlegemechanik mit einem Drahtzufuhrgreifer G_{Z} und einem gegenüber diesem in der Stringrichtung S verfahrbaren Drahttransportgreifer G_{T}, die beide über dem Wafertisch 1 angeordnet sind. Außerdem weist die Drahtlegemechanik eine unter dem Wafertisch 1 angeordnete Drahthaltegreifermechanik auf, die im gezeigten Beispiel mehrere einzelne Drahthaltegreifer G₀, G₁, ..., Gₙ umfasst, wie sie in Fig. 2 detaillierter zu erkennen sind. Die Drahthaltegreifer G₀ bis Gₙ sind vor dem vordersten Chuck C₁, zwischen je zwei Chucks C₁ bis Cₙ und hinter einem letzten Chuck Cₙ angeordnet und dafür eingerichtet, die Kontaktdrähte an der betreffenden Position zu greifen und zu halten.

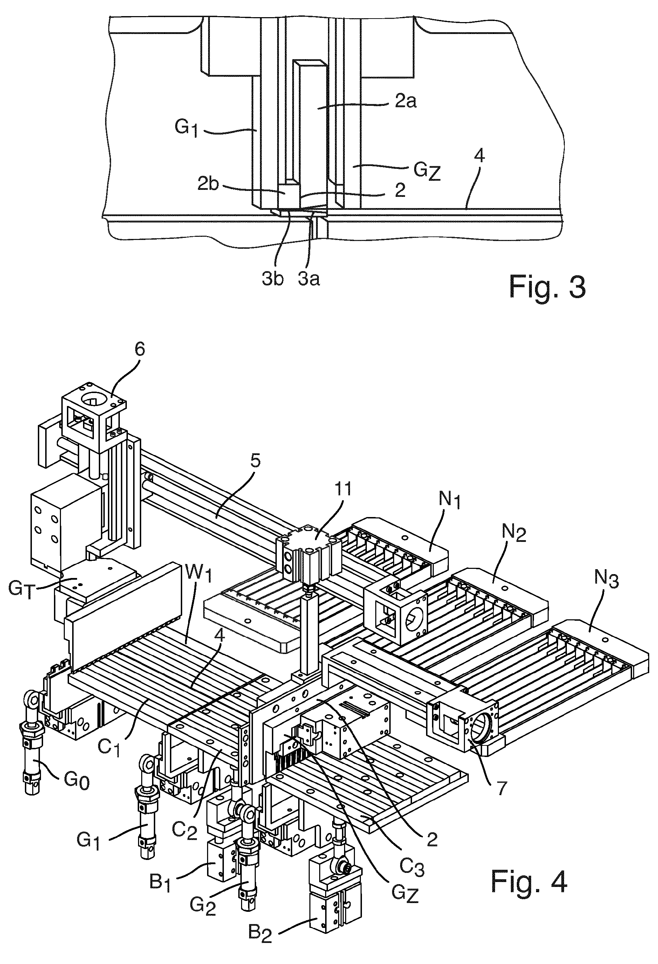

Die Drahtlegemechanik weist zudem einen Drahtschneider 2 auf, der im gezeigten Beispiel durch zwei planparallel aneinanderliegende und gegeneinander senkrecht zur Stringrichtung S bewegliche Schneidplatten 2a, 2b gebildet ist. Diese relative Vertikalbewegung der beiden Schneidplatten 2a, 2b wird durch einen zugehörigen Vertikalantrieb 11 bewirkt. Wie in der Detailansicht von Fig. 3 genauer zu erkennen, sind die Schneidplatten 2a, 2b mit korrespondierenden Durchführungsöffnungen 3a, 3b versehen, durch die jeweils ein Kontaktdraht 4 durchgeführt wird, wenn sich die Öffnungen 3a, 3b in fluchtender Stellung befinden. Durch das gegenseitige Verschieben der beiden Schneidplatten 2a, 2b in ihrer Plattenebene senkrecht zur Stringrichtung S verschieben sich die Durchführungsöffnungen 3a, 3b gegeneinander, wodurch der jeweils durchgeführte Kontaktdraht 4 an dieser Stelle abgetrennt wird. Wie aus Fig. 3 weiter zu erkennen, besitzen die Durchführungsöffnungen 3a einer zufuhrseitigen Schneidplatte 2a eine sich konisch verjüngende Form, während die Durchführungsöffnungen 3b der anderen, drahtaustrittsseitigen Schneidplatte 2b als zylindrische Bohrungen ausgeführt sind.

Weiter umfasst die Vorrichtung jeweils einen Niederhalter N₁, N₂, ..., Nₙ für jede Waferhalteposition C₁ bis Cₙ, um die auf die Oberseite des jeweiligen Solarzellenwafers nach dessen Positionieren auf dem betreffenden Chuck C₁ bis Cₙ aufgelegten Kontaktdrähte für einen anschließenden Löt-/Fixiervorgang in Position zu halten.

Zur Verschiebung längs der Stringrichtung S ist der Drahttransportgreifer G_{T} mit einem zugehörigen Stellantrieb bzw. einer zugehörigen Verfahrachse 5 gekoppelt. Außerdem ist er mit einem weiteren Stellantrieb bzw. einer weiteren Verfahrachse 6 gekoppelt, längs der er vertikal verfahrbar ist, d.h. senkrecht zur Ebene der Waferhaltevorrichtung 1. Um den Drahtzufuhrgreifer G_{Z} in Stringrichtung S verschieben zu können, ist er mit einem entsprechenden Stellantrieb bzw. einer entsprechenden Verfahrachse 7 gekoppelt.

Die serienverschaltenden Kontaktdrähte werden dadurch auf die Oberseite eines vorderen Wafers und die Unterseite eines nächsten Wafers angelegt, dass sie nach Positionieren des vorderen und vor Positionieren des nächsten Wafers auf dem Wafertisch 1 auf die Oberseite des positionierten vorderen Wafers und auf den Chuck für den nächsten, noch nicht dort positionierten Wafer aufgelegt werden. Zum Höhenausgleich zwischen dem Niveau der Oberseite des vorderen Wafers und dem Chuck für den nächsten Wafer bzw. der Unterseite des anschließend positionierten nächsten Wafers werden die Kontaktdrähte im Übergangsbereich geeignet gebogen bzw. abgeknickt. Dazu weist die Drahtlegemechanik eine Drahtbiegemechanik mit Drahtbiegern B_{1, ...,} Bₙ₋₁ auf, die unterhalb des Wafertischs 1 jeweils im Übergangsbereich zwischen zwei Chucks C₁ bis Cₙ₋₁ neben den dortigen Drahthaltegreifern G₁ bis Gₙ₋₁ angeordnet sind. Die Drahthaltegreifer G₀ bis Gₙ und die Drahtbieger B₁ bis Bₙ₋₁ sind jeweils mittels entsprechender Stellantriebe vertikal beweglich angeordnet.

Zur Steuerung aller obengenannten Komponenten weist die Vorrichtung eine Maschinensteuerung 8 mit zugehörigen Eingängen 8a und Ausgängen 8b auf, wie sie lediglich schematisch in Fig. 1 dargestellt ist. Die Maschinensteuerung 8 ist von irgendeinem für solche Maschinensteuerungszwecke üblichen Typ, was hier folglich keiner näheren Erläuterungen bedarf. Insbesondere sind in der Maschinensteuerung 8 Drahtlege-Steuermittel implementiert, welche die Komponenten der Drahtlegemechanik zum Ausführen eines im Folgenden näher erläuterten Drahtlegevorgangs steuern. Die Implementierung der Drahtlege-Steuermittel kann der Fachmann nach Wahl mittels geeigneter Hardware und/oder Software vornehmen, was hier ebenfalls keiner näheren Erläuterungen bedarf. Alternativ zu dieser Integration in die zentrale Maschinensteuerung 8 können die Drahtlege-Steuermittel auch als eine separate Steuereinheit realisiert sein. Wesentlich ist insoweit nur ihre Steuerungsfunktion, wie sie sich aus den nachstehenden Erläuterungen ergibt.

Im Folgenden wird detaillierter auf die einzelnen Schritte eines Verfahrens zum Anbringen von serienverschaltenden Solarzellen-Kontaktdrähten eingegangen, wie es von einer erfindungsgemäßen Vorrichtung unter der Steuerung durch die Drahtlege-Steuermittel 8 ausgeführt wird. Die Fig. 2 bis 12 veranschaulichen aufeinanderfolgende Prozessstadien dieses Vorgangs am Beispiel des Auflegens von Kontaktdrähten 4 auf die Oberseite eines vordersten Solarzellenwafers W₁ eines zu bildenden Solarzellenstrings und auf die Unterseite des nächsten, zweiten Solarzellenwafers im String. Dabei wird gleichzeitig eine Mehrzahl von parallelen Kontaktdrähten angebracht, wie dies aus dem eingangs erwähnten Stand der Technik an sich bekannt ist, z.B. 8 bis 20 Kontaktdrähte, wobei der Übersichtlichkeit halber nur in einigen der Figuren einer der Kontaktdrähte 4 stellvertretend gezeigt ist. Die Kontaktdrähte 4 werden in ebenfalls an sich bekannter Weise in einer Reihe liegend von zugehörigen Vorratsspulen abgezogen und parallel zur Stringrichtung S auf der Oberseite bzw. der Unterseite der Solarzellenwafer mit einem vorgebbaren Querabstand angebracht, der von der Waferbreite und der Anzahl paralleler Kontaktdrähte abhängt.

Fig. 2 zeigt den Beginn eines serienverschaltenden Drahtlegevorgangs, mit welchem die Kontaktdrähte 4 durchgehend auf die Oberseite des bereits auf dem ersten Chuck C₁ positionierten ersten Solarzellenwafers W₁ und der Unterseite des nächsten Solarzellenwafers angebracht werden, der noch nicht auf dem zugehörigen Chuck C₂ positioniert ist. Zuvor wird eine Reihe von Kontaktdrähten an der Unterseite des ersten Wafers W₁ angebracht, wobei sich der Wafertisch noch um eine Waferlänge, d.h. um einen Chuck, weiter hinten befindet, so dass sich der erste Chuck C₁ dort befindet, wo in Fig. 2 der zweite Chuck C₂ ist. Dazu werden mit Hilfe des Drahttransportgreifers G_{T} die Kontaktdrähte über dem ersten Chuck C₁ aufgespannt, durch die beiden zugehörigen Drahthaltegreifer G₀ und G₁ gegriffen und gehalten und durch den Drahtschneider 2 abgeschnitten, bevor der erste Wafer W₁ darauf positioniert wird. Dann wird der Wafertisch 1 wird um eine Chucklänge in die Stellung von Fig. 2 vorbewegt. Der Drahttransportgreifer G_{T} kehrt wieder in seine Ausgangsposition von Fig. 2 zurück, und der erste Wafer W₁ wird auf den mit den Kontaktdrähten versehenen ersten Chuck C₁ aufgelegt.

Dann kann der Drahtlegevorgang für das Serienverschalten des ersten Wafers W₁ mit dem nächsten Wafer beginnen. Zuerst übergibt dazu der Drahtzufuhrgreifer G_{Z} die ihm zugeführten Kontaktdrähte 4 mit ihren Enden an den Drahttransportgreifer G_{T}. Dazu bewegt sich der Drahtzufuhrgreifer G_{Z,} der die Kontaktdrähte 4 nach dem Abschneiden zum Belegen des ersten Chucks C₁ weiter festhält, in Stringrichtung S ein Stück vor, z.B. um ca. 10 mm, woraufhin der Drahttransportgreifer G_{T} die Kontaktdrähte 4 an die ihm dadurch zugänglichen werdenden Enden greift und festhält. Fig. 3 zeigt diesen Übernahmevorgang, bei dem der Drahtzufuhrgreifer G_{Z} sich an den Drahtschneider 2 heranbewegt und die Kontaktdrahtenden durch den Drahtschneider 2 hindurch vorschiebt, so dass sie auf der anderen Seite vom an den Drahtschneider 2 heranbewegten Drahttransportgreifer G_{T} gegriffen werden können. Hierbei wird der Drahttransportgreifer G_{T} von einer Drahtfreigabestellung in eine Drahtklemmstellung umgesteuert. Anschließend wird umgekehrt der Drahtzufuhrgreifer G_{Z} von seiner Drahtklemmstellung in seine Drahtfreigabestellung umgesteuert. Nun können die Kontaktdrähte 4 vom Drahttransportgreifer G_{T} in Stringrichtung S nach vorn um ca. zwei Waferlängen bis zur Vorderkante des ersten Solarzellenwafers W₁ vorbewegt werden, z.B. um ca. 300 mm.

Fig. 4 zeigt die Vorrichtung in diesem Prozessstadium. Der Drahttransportgreifer G_{T} befindet sich in einer vorbewegten Stellung vor dem ersten Wafer W₁. Nun wird der Drahtzufuhrgreifer G_{Z} in seine Drahtklemmstellung umgeschaltet und zum Recken, d.h. gestreckten Spannen, der Kontaktdrähte 4 über dem ersten Wafer W₁ und dem zweiten Chuck C₂ um eine vorgebbare Recklänge von z.B. ca. 30mm in Stringrichtung S zurückbewegt, d.h. in Fig. 4 nach rechts. Direkt anschließend wird der Drahtzufuhrgreifer G_{Z} um eine geringfügige, vorgegebene Entspannungslänge von z.B. ca. 1mm in Stringrichtung S vorbewegt, um die gereckten Kontaktdrähte 4 entsprechend etwas zu entspannen.

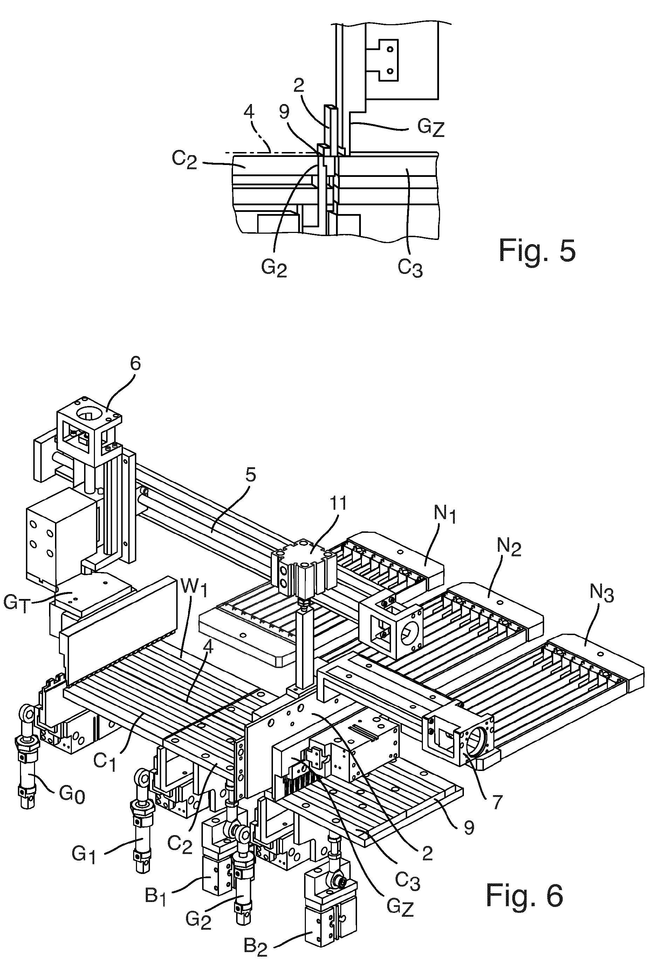

Nun wird der zwischen dem zweiten und dem dritten Chuck C₂, C₃ angeordnete Drahthaltegreifer G₂ in einer Drahtfreigabestellung durch einen im Wafertisch 1 gebildeten Zwischenraum hindurch vertikal nach oben bewegt, bis er die gespannten Kontaktdrähte 4 zu fassen bekommt. Dann wird er in eine Drahtklemmstellung umgesteuert. Hierbei ist der Zwischenraum für jeden zwischen zwei Chucks angeordneten Drahthaltegreifer G₁ bis Gₙ₋₁ im gezeigten Beispiel durch eine jeweilige schlitzförmige Queröffnung 9 am hinteren Ende jedes Chucks C₁ bis Cₙ gebildet. Fig. 5 zeigt in einer Detailansicht, wie der Drahthaltegreifer G₂ durch den Zwischenraum 9 am hinteren Ende des zweiten Chucks C₂ hindurchgreift und die gespannten Kontaktdrähte 4 direkt vor dem Messerschneider 2 festhält.

Daraufhin wird der Drahtzufuhrgreifer G_{Z} in seine Drahtfreigabestellung umgesteuert und in Stringrichtung S um eine vorgebbare Distanzlänge von z.B. ca. 19mm zurückgefahren, d.h. vom Drahtschneider 2 weg. Dann wird er wieder in seine Klemmstellung geschaltet, um die von den Vorratsspulen zugeführten Kontaktdrähte 4 auf dieser Seite des Drahtschneiders 2 festzuhalten. Nun wird der Drahtschneider 2 aktiviert, wodurch die Kontaktdrähte 4 an der Drahtschneiderposition zwischen dem die Kontaktdrähte 4 auf der Zufuhrseite festhaltenden Drahttransportgreifer G_{Z} und dem die Kontaktdrähte 4 auf der anderen Seite des Drahtschneiders 2 festhaltenden Drahthaltegreifer G₂ abgeschnitten werden. Dies erfolgt durch relative Vertikalbewegung der beiden Schneidplatten 2a, 2b gegeneinander, wodurch deren zugehörige Durchtrittsöffnungen 3a, 3b aus ihrer fluchtenden Stellung bewegt werden, so dass die durchgeführten Kontaktdrähte 4 dort abgetrennt werden. Fig. 6 zeigt die Vorrichtung in diesem Prozessstadium.

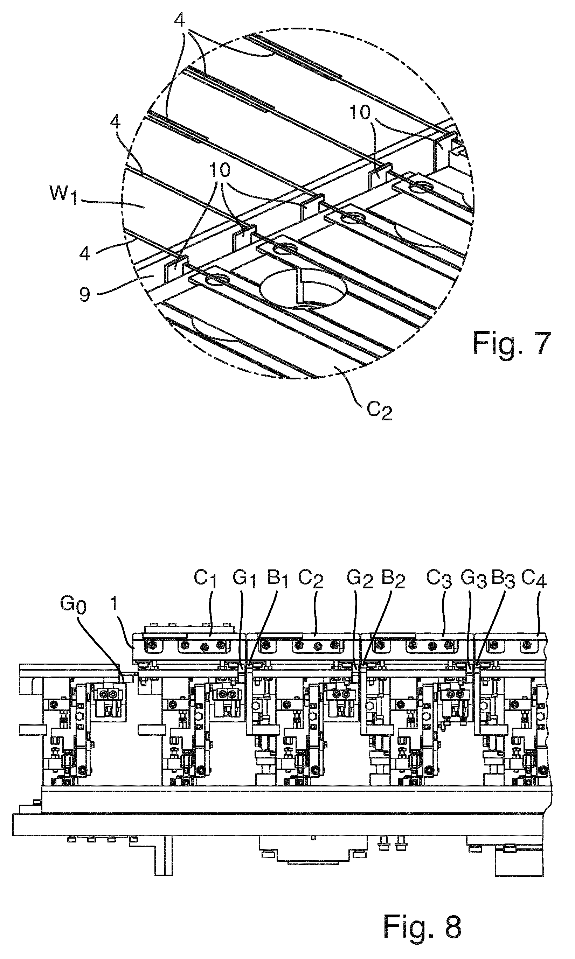

Als Nächstes wird der Drahthaltegreifer G₂ wieder in seine untere Stellung vertikal zurückgefahren, wodurch die Kontaktdrähte 4 auf die Oberseite des zweiten Chucks C₂ unter Spannung aufgelegt werden, wobei die Chucks C₁ bis Cₙ an ihren Oberseiten entsprechende Drahtaufnahmerillen aufweisen können. An der gegenüberliegenden Vorderkante des zweiten Chucks C₂ wird der dort befindliche Drahtbieger B₁ aktiviert, d.h. von einer oberen Ausgangsposition vertikal nach unten in eine Drahtfixierstellung bewegt. Dies bedeutet, dass er mit hakenförmigen Drahtbiegeelementen 10 die gespannten Kontaktdrähte 4 in diesem Bereich erfasst und so weit von oben nach unten mitnimmt, bis die Kontaktdrähte 4 in einem etwa Z-förmigen Verlauf vom höheren Niveau der Oberseite des auf dem ersten Chuck C₁ positionierten ersten Wafers W₁ auf das niedrigere Niveau der Oberseite des zweiten Chucks C₂ übergehen. Dazu weist der jeweilige Drahtbieger B₁ bis Bₙ₋₁ für jeden Kontaktdraht 4 jeweils ein solches Biegeelement 10 auf, wie sie aus der Detailansicht von Fig. 7 erkennbar sind.

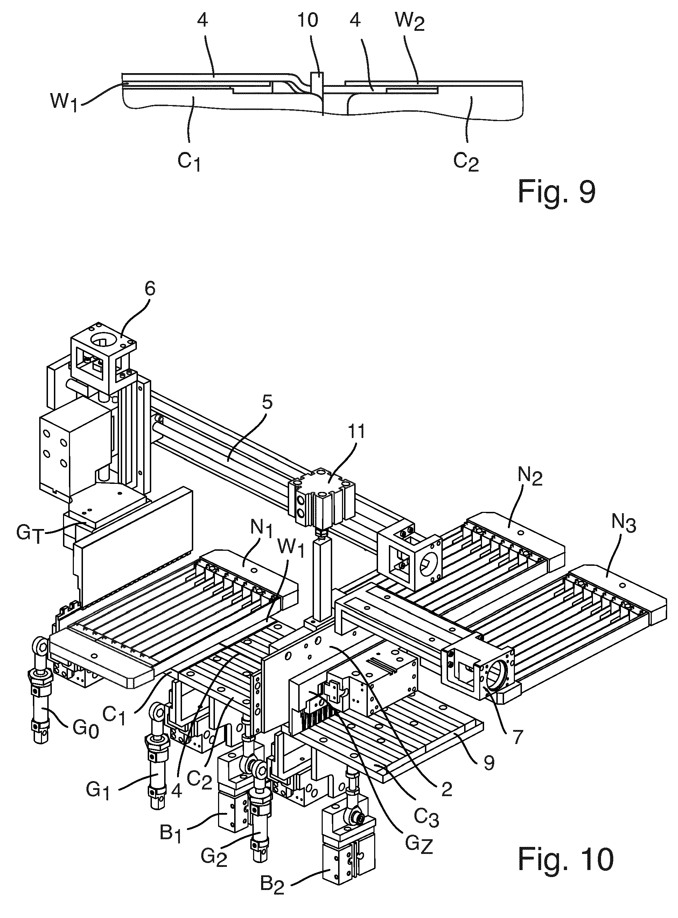

Der Drahtbieger B₁ bis Bₙ₋₁ befindet sich jeweils direkt neben dem entsprechenden Drahthaltegreifer G₁ bis Gₙ₋₁ im Übergangsbereich zwischen je zwei Chucks C₁ bis Cₙ, wie dies aus der Detailseitenansicht von Fig. 8 näher ersichtlich ist. Der jeweilige Drahtbieger B₁ bis Bₙ₋₁ kann auf diese Weise mit seinen Drahtbiegeelementen 10 durch die gleichen Zwischenräume 9 vertikal hindurchgreifen wie die jeweils benachbarten Drahthaltegreifer G₁ bis Gₙ₋₁, wozu die Zwischenräume 9 wie erwähnt am hinteren Endbereich oder alternativ am vorderen Endbereich eines jeden Chucks C₁ bis Cₙ oder zwischen je zwei Chucks vorgesehen sind. Der Drahtbieger B₁ fixiert dann in seiner Drahtfixierstellung die Kontaktdrähte 4 in ihrem abgebogenen bzw. abgeknickten Übergangsbereich vom ersten Wafer W₁ zum zweiten Chuck C₂, wie dies in einer Detailseitenansicht von Fig. 9 zu erkennen ist, die diesen Bereich in einem späteren Prozessstadium nach Auflegen des zweiten Wafers W₂ zeigt.

Anschließend wird der zugehörige Drahtniederhalter N₁ auf die mit den gespannten Kontaktdrähten 4 versehene Oberseite des ersten Wafers W₁ aufgelegt. Der Niederhalter N₁ fixiert dadurch die Kontaktdrähte 4 auf der Oberseite des ersten Wafers W₁. Fig. 10 zeigt die Vorrichtung in diesem Prozessstadium.

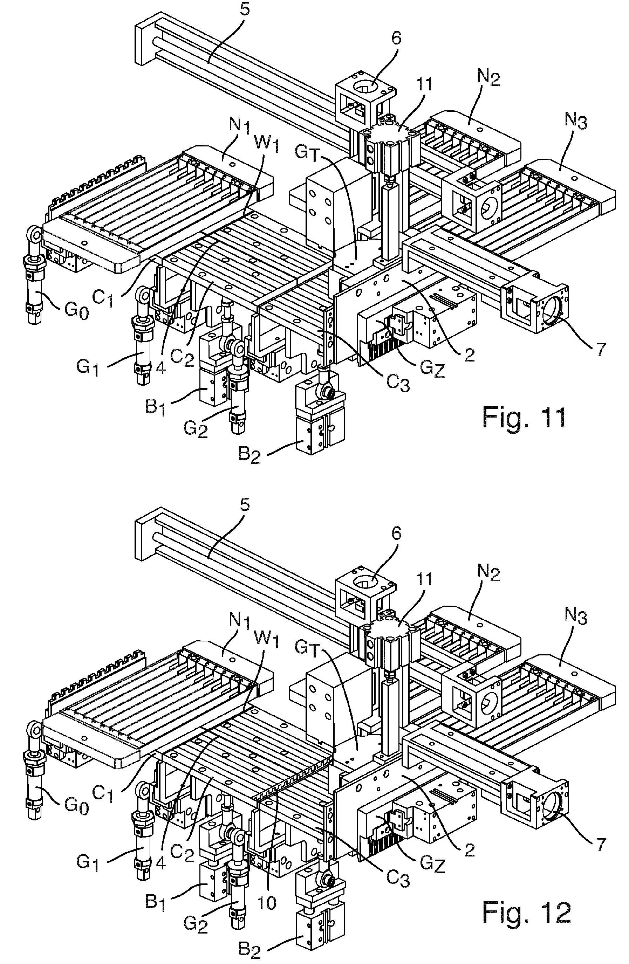

Daraufhin kann der Drahttransportgreifer G_{T} die durch den Niederhalter N₁ fixierten Kontaktdrähte 4 loslassen, wozu er in seine Drahtfreigabestellung umgesteuert wird. Dann wird er um eine vorgegebene Distanzhöhe von z.B. 30mm vertikal nach oben bewegt. Dadurch gelangt der Drahttransportgreifer G_{T} auf ein Niveau über dem Niederhalter N₁ und kann nun wieder in Stringrichtung S bis hinter den Drahtschneider 2 zurückbewegt werden, d.h. um die doppelte Chucklänge von z.B. ca. 300mm. Danach wird er um die vormals angehobene Distanzhöhe von z.B. 30mm in seine Ausgangsposition vertikal nach unten bewegt. Der Wafertisch 1 wird dann mit den unterseitigen Vorrichtungskomponenten, wie den Drahthaltegreifern G₀ bis Gₙ und den Drahtbiegern B₁ bis Bₙ₋₁, um eine Chucklänge in Stringrichtung S relativ zu den darüberliegenden Vorrichtungskomponenten vorbewegt, d.h. in Fig. 10 nach links. Fig. 11 zeigt die Vorrichtung in diesem Prozessstadium.

Zur Vorbereitung des nächsten Drahtlegevorgangs wird dann der zwischen dem zweiten und dritten Chuck C₂, C₃ liegende Drahtbieger B₂ durch den betreffenden Zwischenraum 9 am hinteren Endbereich des zweiten Chucks C₂ hindurch vertikal nach oben bewegt. Fig. 12 zeigt die Vorrichtung in diesem Prozessstadium, in welcher der erste serienverschaltende Drahtlegevorgang für den zu bildenden Solarzellenstring abgeschlossen und die Vorrichtung zur Durchführung des nächsten Drahtlegevorgangs bereit ist, in welchem die Kontaktdrähte zum seriellen Verbinden der Oberseite des zweiten Wafers W₂ mit der Unterseite des dritten Wafers W₃ angebracht werden. Zuerst wird dazu der zweite Wafer W₂ auf den mit den gespannten Kontaktdrähten 4 versehenen zweiten Chuck C₂ im Stadium von Fig. 12 aufgelegt. Dann kann der nächste Satz von Kontaktdrähten 4 angebracht werden, dieses Mal auf die Oberseite des positionierten zweiten Wafers W₂ und auf den dritten Chuck C₃ des dort noch nicht positionierten dritten Wafers W₃, wie oben zum vorausgegangenen Drahtlegevorgang beschrieben.

In dieser Weise wird bis zum letzten Wafer Wₙ des Solarzellenstrings vorgegangen. Als abschließender Prozess der Bildung des Solarzellenstrings wird dann noch die Oberseite dieses letzten Wafers Wₙ mit den Kontaktdrähten 4 belegt. Dazu zieht der Drahttransportgreifer G_{T} die Kontaktdrähte 4 nur noch um eine Waferlänge vor, der hinter dem letzten Chuck Cₙ positionierte Drahthaltegreifer Gₙ greift die Kontaktdrähte 4 hinter dem Drahtschneider 2 und zieht sie nach deren Abschneiden nach unten. Dann wird der zugehörige Niederhalter Nₙ auf die mit den gespannten Kontaktdrähten 4 versehene Oberseite des letzten Wafers Wₙ aufgelegt.

Wenn auf die beschriebene Weise alle Wafer W₁ bis Wₙ des Solarzellenstrings auf ihren zugehörigen Chucks C₁ bis Cₙ des Wafertischs 1 positioniert und oberseitig und unterseitig mit den Kontaktdrähten 4 unter Fixierung durch die Niederhalter N₁ bis Nₙ belegt sind, erfolgt die dauerhafte Fixierung der Kontaktdrähte 4 auf den Oberseiten und Unterseiten der Stringwafer W₁ bis Wₙ durch einen herkömmlichen Fixierprozess, beispielsweise durch einen Lötprozess, bei dem die Wafer W₁ bis Wₙ auf ihren Chucks C₁ bis Cₙ im Durchlaufverfahren durch eine Lötvorrichtung, wie einen Lötofen, hindurchbewegt werden.

Wie die obige Beschreibung vorteilhafter Ausführungsbeispiele deutlich macht, stellt die Erfindung eine erfindungsgemäße Vorrichtung und ein erfindungsgemäßes Verfahren zur Verfügung, mit denen sich die Kontaktdrähte zum serienverschaltenden Verbinden bzw. frontseitigen und rückseitigen Kontaktieren von zu einem String zusammenzuschaltenden Solarzellenwafern durch einen besonders vorteilhaften Drahtlegevorgang auf den Oberseiten und Unterseiten der Solarzellenwafer anbringen lassen.

## Patentansprüche

1. Vorrichtung zum Anbringen von serienverschaltenden Solarzellen-Kontaktdrähten (4), die in einer Stringrichtung (5) durchgehend auf einer Oberseite eines vorderen Solarzellenwafers (W₁) und einer Unterseite eines auf den vorderen Solarzellenwafer in einem zu bildenden Solarzellenstring folgenden, hinteren Solarzellenwafers (W₂) verlaufen, mit
- einer Waferhaltevorrichtung (1), auf der die Solarzellenwafer in der Stringrichtung hintereinander an zugehörigen Waferhaltepositionen (C₁ bis Cₙ) positionierbar sind,
- einer Drahtlegemechanik mit einem Drahtzufuhrgreifer (G_{Z}) und einem gegenüber diesem in der Stringrichtung verfahrbaren Drahttransportgreifer (G_{T}), die über der Waferhaltevorrichtung angeordnet sind, einem Drahthaltegreifer (G₁) der dafür eingerichtet ist, die Kontaktdrähte hinter der Waferhalteposition für den hinteren Solarzellenwafer zu greifen und zu halten, und einem Drahtschneider (2), und
- Drahtlege-Steuermitteln (8), welche die Drahtlegemechanik zum Ausführen eines Drahtlegevorgangs steuern, bei dem nach Positionieren des vorderen Solarzellenwafers und vor Positionieren des hinteren Solarzellenwafers auf ihrer jeweiligen Waferhalteposition die Kontaktdrähte vom Drahtzufuhrgreifer an den Drahttransportgreifer übergeben, vom Drahttransportgreifer in der Stringrichtung über die Waferhalteposition für den hinteren Solarzellenwafer und über die Oberseite des positionierten vorderen Solarzellenwafers vorbewegt, hinter der Waferhalteposition für den hinteren Solarzellenwafer vom Drahthaltegreifer gegriffen und gehalten und anschließend hinter dem Drahthaltegreifer vom Drahtschneider abgeschnitten werden.

2. Vorrichtung nach Anspruch 1, weiter **dadurch gekennzeichnet, dass** die Drahtlege-Steuermittel zur Übergabe der Kontaktdrähte vom Drahtzufuhrgreifer an den Drahttransportgreifer den Drahtzufuhrgreifer von einer Drahtklemmstellung in eine Drahtfreigabestellung und den Drahttransportgreifer von einer Drahtfreigabestellung in eine Drahtklemmstellung steuern.

3. Vorrichtung nach Anspruch 1 oder 2, weiter **dadurch gekennzeichnet, dass** der Drahtschneider zwischen dem Drahtzufuhrgreifer und dem Drahthaltegreifer angeordnet ist und die Drahtlege-Steuermittel den Drahtzufuhrgreifer von einer Drahtfreigabestellung in eine Drahtklemmstellung steuern, bevor sie den Drahtschneider zum Abschneiden der Kontaktdrähte aktivieren.

4. Vorrichtung nach einem der Ansprüche 1 bis 3, weiter **dadurch gekennzeichnet, dass** der Drahtschneider eine senkrecht zur Stringrichtung angeordnete, zufuhrseitige Schneidplatte (2a) und eine planparallel an dieser anliegende zweite Schneidplatte (2b) beinhaltet, wobei die beiden Schneidplatten in ihrer planparallelen Ebene gegeneinander verschiebbar und mit korrespondierenden, in Stringrichtung verlaufenden Drahtdurchführungsöffnungen (3a, 3b) versehen sind, von denen die Drahtdurchführungsöffnungen der zufuhrseitigen Schneidplatte eine konisch verjüngte Form aufweisen.

5. Vorrichtung nach einem der Ansprüche 1 bis 4, weiter **dadurch gekennzeichnet, dass** die Drahtlegemechanik einen Drahtbieger (B₁) aufweist, der zum Biegen der über die Waferhalteposition für den hinteren Solarzellenwafer und über die Oberseite des vorderen Solarzellenwafers vorbewegten Kontaktdrähte zwischen der Oberseite des vorderen Solarzellenwafers und der Waferhalteposition für den hinteren Solarzellenwafer eingerichtet ist.

6. Verfahren zum Anbringen von serienverschaltenden Solarzellen-Kontaktdrähten (4), die in einer Stringrichtung (5) durchgehend auf einer Oberseite eines vorderen Solarzellenwafers (W₁) und einer Unterseite eines auf den vorderen Solarzellenwafer in einem zu bildenden Solarzellenstring folgenden, hinteren Solarzellenwafers (W₂) verlaufen, mit folgenden Schritten:
- Positionieren des vorderen Solarzellenwafers auf einer zugehörigen Waferhalteposition (C₁) einer Waferhaltevorrichtung (1),
- Übergeben der Kontaktdrähte von einem über der Waferhaltevorrichtung angeordneten Drahtzufuhrgreifer (G_{Z}) an einen Drahttransportgreifer (G_{T}),
- Vorbewegen der Kontaktdrähte durch den Drahttransportgreifer in der Stringrichtung über eine Waferhalteposition (C₂) für den hinteren Solarzellenwafer und über die Oberseite des positionierten vorderen Solarzellenwafers,
- Greifen und Halten der Kontaktdrähte hinter der Waferhalteposition für den hinteren Solarzellenwafer durch einen Drahthaltegreifer (G₂) und hinter dem Drahthaltegreifer durch den Drahtzufuhrgreifer,
- Abschneiden der Kontaktdrähte hinter dem Drahthaltegreifer und vor dem Drahtzufuhrgreifer durch einen Drahtschneider (2) und
- Positionieren des hinteren Solarzellenwafers auf seiner zugehörigen Waferhalteposition.

7. Verfahren nach Anspruch 6, weiter **dadurch gekennzeichnet, dass** zum Übergeben der Kontaktdrähte vom Drahtzufuhrgreifer an den Drahttransportgreifer der Drahtzufuhrgreifer von einer Drahtklemmstellung in eine Drahtfreigabestellung und der Drahttransportgreifer von einer Drahtfreigabestellung in eine Drahtklemmstellung gesteuert werden.

8. Verfahren nach Anspruch 6 oder 7, weiter **dadurch gekennzeichnet, dass** das Abschneiden der Kontaktdrähte zwischen dem Drahtzufuhrgreifer und dem Drahthaltegreifer erfolgt und zuvor der Drahtzufuhrgreifer von einer Drahtfreigabestellung in eine Drahtklemmstellung gesteuert wird.

9. Verfahren nach einem der Ansprüche 6 bis 8, weiter **dadurch gekennzeichnet, dass** die vorbewegten Kontaktdrähte zwischen der Oberseite des vorderen Solarzellenwafers und der Waferhalteposition für den hinteren Solarzellenwafer mittels eines Drahtbiegers (B₁) von einem Niveau der Oberseite des vorderen Solarzellenwafers auf ein Niveau der Waferhalteposition für den hinteren Solarzellenwafer abgebogen werden.

10. Verfahren nach einem der Ansprüche 6 bis 9, weiter **dadurch gekennzeichnet, dass** nach dem Vorbewegen der Kontaktdrähte ein Niederhalter (N₁) auf die Oberseite des vorderen Solarzellenwafers aufgelegt wird, der die Kontaktdrähte dort in Position hält, und der Drahttransportgreifer nach Loslassen der Kontaktdrähte in eine Position zur erneuten Kontaktdrahtübergabe vom Drahtzufuhrgreifer zurückbewegt wird.

## Claims

1. Device for fitting solar cell contact wires (4) providing a series connection, said contact wires running continuously in a string direction (5) on an upper side of a front solar cell wafer (W₁) and an underside of a rear solar cell wafer (W₂) following the front solar cell wafer in a solar cell string to be formed, comprising
- a wafer-holding device (1), on which the solar cell wafers can be positioned in succession in the string direction in respective wafer-holding positions (C₁ to Cₙ),
- a wire-laying mechanism having a wire feed gripper (G_{Z}) and a wire transport gripper (G_{T}) movable in the string direction relative to the wire feed gripper, the grippers being arranged above the wafer-holding device, a wire-holding gripper (G₁) which is designed to grip and to hold the contact wires behind the wafer-holding position for the rear solar cell wafer, and a wire cutter (2), and
- wire-laying control means (8), which control the wire-laying mechanism to carry out a wire-laying procedure, in which, once the front solar cell wafer has been positioned in its respective wafer-holding position and before the rear solar cell wafer has been positioned in its respective wafer-holding position, the contact wires are transferred from the wire feed gripper to the wire transport gripper, are advanced by the wire transport gripper in the string direction over the wafer-holding position for the rear solar cell wafer and over the upper side of the positioned front solar cell wafer, are gripped and held by the wire-holding gripper behind the wafer-holding position for the rear solar cell wafer, and are subsequently cut off behind the wire-holding gripper by the wire cutter.

2. Device according to Claim 1, further **characterized in that** the wire-laying control means, in order to transfer the contact wires from the wire feed gripper to the wire transport gripper, control the wire feed gripper from a wire-clamping position into a wire release position and control the wire transport gripper from a wire release position into a wire-clamping position.

3. Device according to Claim 1 or 2, further **characterized in that** the wire cutter is arranged between the wire feed gripper and the wire-holding gripper, and the wirelaying control means control the wire feed gripper from a wire release position into a wire-clamping position, before they activate the wire cutter to cut off the contact wires.

4. Device according to any of Claims 1 to 3, further **characterized in that** the wire cutter includes a feed-side cutting plate (2a) arranged perpendicular to the string direction and a second cutting plate (2b) bearing against said feed-side cutting plate in a plane-parallel manner, the two cutting plates being displaceable with respect to one another in their plane-parallel plane and being provided with corresponding wire feedthrough openings (3a, 3b) running in the string direction, of which the wire feedthrough openings of the feed-side cutting plate have a conically tapered shape.

5. Device according to any of Claims 1 to 4, further **characterized in that** the wire-laying mechanism comprises a wire bender (B₁) which is configured to bend the contact wires, advanced over the wafer-holding position for the rear solar cell wafer and over the upper side of the front solar cell wafer, between the upper side of the front solar cell wafer and the wafer-holding position for the rear solar cell wafer.

6. Method for fitting solar cell contact wires (4) providing a series connection, said contact wires running continuously in a string direction (5) on an upper side of a front solar cell wafer (W₁) and an underside of a rear solar cell wafer (W₂) following the front solar cell wafer in a solar cell string to be formed, comprising the following steps:
- positioning the front solar cell wafer in a respective wafer-holding position (C₁) of a wafer-holding device (1),
- transferring the contact wires from a wire feed gripper (G_{Z}) arranged above the wafer-holding device to a wire transport gripper (G_{T}),
- advancing the contact wires by the wire transport gripper in the string direction over a wafer-holding position (C₂) for the rear solar cell wafer and over the upper side of the positioned front solar cell wafer,
- gripping and holding the contact wires behind the wafer-holding position for the rear solar cell wafer by means of a wire-holding gripper (G₂) and behind the wire-holding gripper by means of the wire feed gripper,
- cutting off the contact wires behind the wire-holding gripper and in front of the wire feed gripper by means of a wire cutter (2), and
- positioning the rear solar cell wafer in its respective wafer-holding position.

7. Method according to Claim 6, further **characterized in that**, in order to transfer the contact wires from the wire feed gripper to the wire transport gripper, the wire feed gripper is controlled from a wire-clamping position into a wire release position and the wire transport gripper is controlled from a wire release position into a wire clamping position.

8. Method according to Claim 6 or 7, further **characterized in that** the contact wires are cut off between the wire feed gripper and the wire-holding gripper and the wire feed gripper is controlled beforehand from a wire release position into a wire-clamping position.

9. Method according to any of Claims 6 to 8, further **characterized in that** the advanced contact wires between the upper side of the front solar cell wafer and the wafer-holding position for the rear solar cell wafer are bent by means of a wire bender (B₁) from a level of the upper side of the front solar cell wafer to a level of the wafer-holding position for the rear solar cell wafer.

10. Method according to any of Claims 6 to 9, further **characterized in that**, once the contact wires have been advanced, a hold-down device (N₁) is placed on the upper side of the front solar cell wafer and holds the contact wires in position there, and the wire transport gripper, once the contact wires have been disengaged, is moved back into a position for renewed contact wire transfer from the wire feed gripper.

## Revendications

1. Dispositif pour appliquer des fils de contact (4) de cellules solaires connectant en série, les fils s'étendant continuellement dans une direction de chaîne (5) sur une face supérieure d'un wafer de cellules solaires (W₁) frontal et une face inférieure d'un wafer de cellules solaires (W₂) arrière suivant le wafer de cellules solaires frontal dans une chaîne de cellules solaires à former, comprenant
- un dispositif de retenue de wafer (1), sur lequel les wafers de cellules solaires sont positionnables l'un derrière l'autre à des positions de retenue de wafer (C₁ à Cₙ) respectives,
- un mécanisme de pose de fil avec un préhenseur d'amenage de fil (G_{Z}) et un préhenseur de transport de fil (G_{T}) déplaçable par rapport au préhenseur d'amenage de fil dans la direction de chaîne, les préhenseurs étant disposés au-dessus du dispositif de retenue de wafer, un préhenseur de retenue de fil (G₁) configuré pour saisir et retenir les fils de contact derrière la position de retenue de wafer pour le wafer de cellules solaires arrière, et un coupe-fil (2), et
- des moyens de commande de pose de fil (8) pour commander le mécanisme de pose de fil à opérer une procédure de pose de fil, dans lequel après positionner le wafer de cellules solaires frontal et avant de positionner le wafer de cellules solaires arrière sur sa position de retenue de wafer respective, les fils de contact sont transférés du préhenseur d'amenage de fil au préhenseur de transport de fil, sont avancés par le préhenseur de transport de fil dans la direction de chaîne à travers la position de retenue de wafer pour le wafer de cellules solaires arrière et à travers la face supérieure du wafer de cellules solaires frontal positionné, sont saisis et retenus par le préhenseur de retenue de fil derrière la position de retenue de wafer pour le wafer de cellules solaires arrière et ensuite sont coupés par le coupe-fil derrière le préhenseur de retenue de fil.

2. Dispositif selon la revendication 1, en outre **caractérisé en ce que**, pour transférer les fils de contact du préhenseur d'amenage de fil au préhenseur de transport de fil, les moyens de commande de pose de fil commandent le préhenseur d'amenage de fil d'une position de serrage de fil à une position de desserrage de fil et le préhenseur de transport de fil d'une position de desserrage de fil à une position de serrage de fil.

3. Dispositif selon la revendication 1 ou 2, en outre **caractérisé en ce que** le coupe-fil est disposé entre le préhenseur d'amenage de fil et le préhenseur de retenue de fil et les moyens de commande de pose de fil commandent le préhenseur d'amenage de fil d'une position de desserrage de fil à une position de serrage de fil, avant d'activer le coupe-fil pour couper les fils de contact.

4. Dispositif selon l'une quelconque des revendications 1 à 3, en outre **caractérisé en ce que** le coupe-fil comporte une planche à découper (2a) côté d'amenage, disposée perpendiculairement par rapport à la direction the chaîne, et une deuxième planche à découper (2b) s'appuyant à celle-ci dans un plan parallèle, dans lequel les deux planches à découper sont déplaçables l'une par rapport à l'autre dans le plan parallèle et sont pourvues d'orifices de passage de fil (3a, 3b) correspondants, s'étendant dans la direction de chaîne, dont les orifices de passage de fil de la planche à découper côté d'amenage présente une forme se rétrécissant de façon conique.

5. Dispositif selon l'une quelconque des revendications 1 à 4, en outre **caractérisé en ce que** le mécanisme de pose de fil comporte un plieur de fil (B₁) configuré pour plier les fils de contact avancés à travers la position de retenue de wafer pour le wafer de cellules solaires arrière et à travers la face supérieure du wafer de cellules solaires frontal entre la face supérieure du wafer de cellules solaires frontal et la position de retenue de wafer pour le wafer de cellules solaires arrière.

6. Procédé pour appliquer des fils de contact (4) de cellules solaires connectant en série, les fils s'étendant continuellement dans une direction de chaîne (5) sur une face supérieure d'un wafer de cellules solaires (W₁) frontal et une face inférieure d'un wafer de cellules solaires (W₂) arrière suivant le wafer de cellules solaires frontal dans une chaîne de cellules solaires à former, comprenant les étapes suivantes:
- positionner le wafer de cellules solaires frontal à une position de retenue de wafer (C₁) respective d'un dispositif de retenue de wafer (1),
- transférer les fils de contact d'un préhenseur d'amenage de fil (G_{Z}) disposé au-dessus du dispositif de retenue de wafer à un préhenseur de transport de fil (G_{T}),
- avancer les fils de contact par le préhenseur de transport de fil dans la direction de chaîne à travers une position de retenue de wafer (C₂) pour le wafer de cellules solaires arrière et à travers la face supérieure du wafer de cellules solaires frontal positionné,
- saisir et retenir les fils de contact derrière la position de retenue de wafer pour le wafer de cellules solaires arrière par un préhenseur de retenue de fil (G₂) et derrière le préhenseur de retenue de fil par le préhenseur d'amenage de fil,
- couper les fils de contact derrière le préhenseur de retenue de fil et avant le préhenseur d'amenage de fil par un coupe-fil (2) et
- positionner le wafer de cellules solaires arrière sur sa position de retenue de wafer respective.

7. Procédé selon la revendication 6, en outre **caractérisé en ce que**, pour transférer les fils de contact du préhenseur d'amenage de fil au préhenseur de transport de fil, le préhenseur d'amenage de fil est commandé d'une position de serrage de fil à une position de desserrage de fil et le préhenseur de transport de fil est commandé d'une position de desserrage de fil à une position de serrage de fil.

8. Procédé selon la revendication 6 ou 7, en outre **caractérisé en ce que** couper les fils de contact se fait entre le préhenseur d'amenage de fil et le préhenseur de retenue de fil et préalablement le préhenseur d'amenage de fil est commandé d'une position de desserrage de fil à une position de serrage de fil.

9. Procédé selon l'une quelconque des revendications 6 à 8, en outre **caractérisé en ce que** les fils de contact avancés sont pliés entre la face supérieure du wafer de cellules solaires frontal et la position de retenue de wafer pour le wafer de cellules solaires arrière par le biais d'un plieur de fil (B₁) d'un niveau de la face supérieure du wafer de cellules solaires frontal à un niveau de la position de retenue de wafer pour le wafer de cellules solaires arrière.

10. Procédé selon l'une quelconque des revendications 6 à 9, en outre **caractérisé en ce qu'**après avancer les fils de contact un serre-flan (N₁) est posé sur la face supérieure du wafer de cellules solaires frontal retenant les fils de contact en position là-bas, et après libération des fils de contact le préhenseur de transport de fil est renvoyé à une position pour transférer des fils de contact du préhenseur d'amenage de fil à nouveau.
